# FASCICULE DE BREVET EUROPEEN

(11) **EP 1 017 102 B1**
(45) Date de publication et mention de la délivrance du brevet: **18.03.2009**
(21) Numéro de dépôt: 99204456.0
(22) Date de dépôt: 21.12.1999
(51) Int. Cl.: H01L 27/06, H01L 27/08, H01L 21/02

(54) **Circuit intégré à éléments inductifs**
Integrierter Schaltkreis mit induktiven Elementen
Integrated circuit comprising inductive elements

(30) Priorité: 29.12.1998 FR 9816569
(43) Date de publication de la demande: 05.07.2000
(73) Titulaire: NXP B.V., 5656 AG Eindhoven (NL)
(72) Inventeur: Jovenin, Fabrice, 75008 Paris (FR); Cercelaru, Sever, 75008 Paris (FR)
(74) Mandataire: van der Veer, Johannis Leendert

(56) Documents cités:
- EP-A- 0 836 271
- WO-A-98/50956
- US-A- 5 070 317
- US-A- 5 173 671
- US-A- 5 478 773
- US-A- 5 798 559
- YUE C P ET AL: "ON-CHIP SPIRAL INDUCTORS WITH PATTERNED GROUND SHIELDS FOR SI -BASEDRF IC'S" IEEE JOURNAL OF SOLID-STATE CIRCUITS, vol. 33, no. 5, 1 mai 1998 (1998-05-01), pages 743-751, XP000785008 ISSN: 0018-9200

## Description

L'invention concerne un circuit intégré comprenant au moins un élément inductif, une zone dite active pouvant inclure des éléments résistifs, capacitifs et semiconducteurs, l'élément inductif et une partie de la zone active étant superposes.

Une méthode de fabrication d'un tel circuit intégré est mentionnée dans le brevet américain No. 5 370 766. Cette méthode a pour but de réduire la surface totale du circuit intégré. Le document WO 98/50956 décrit des blindages de masse à motifs geométriques pour inducteurs de circuits integrés.

L'invention est liée aux considérations suivantes :
La superposition d'un élément inductif avec la zone active peut provoquer l'apparition de mutuelles inductances et de couplages parasites entre l'élément inductif et les éléments de la zone active ayant pour effet de fortement détériorer le facteur de qualité de l'élément inductif et de réduire la précision fréquentielle du circuit.

Une solution déjà connue pour minimiser les problèmes d'interaction entre l'élément inductif et les éléments de la zone active consiste à placer séparément l'élément inductif des autres éléments. Une telle intégration pose alors un problème d'encombrement. En effet les éléments inductifs peuvent nécessiter pour leur réalisation un quart de la surface totale du circuit voir plus.

L'invention a pour but de remédier dans une large mesure à ces inconvénients, en proposant un circuit intégré au sein duquel coexistent au moins un élément inductif et une zone active entre lesquels les interactions électromagnétiques sont réduites sans que l'encombrement du circuit intégré ne s'en trouve augmenté de manière significative.

Un autre but de la présente invention est de permettre l'intégration d'un circuit intégré compact qui comprend au moins un élément inductif présentant un facteur de qualité élevé.

En effet, un circuit intégré conforme au paragraphe introductif est remarquable selon l'invention en ce qu'il est muni de moyens de blindage pour isoler la zone active vis-à-vis d'un champ électromagnétique que l'élément inductif est destiné à développer.

Dans un tel circuit intégré, le champ électromagnétique qui peut être créé par l'élément inductif est, dans une large mesure, bloqué par !es moyens de blindage et son interaction avec les éléments de la zone active est limitée.

L'invention concerne un circuit intégré tel que défini dans la revendication 1.

Dans un mode de réalisation de l'invention, les moyens de blindage sont placés entre l'élément inductif et la zone active et forment un circuit ouvert.

Ce mode de réalisation de l'invention a pour but d'empêcher les moyens de blindage de développer une mutuelle inductance avec l'élément inductif. Dans ce mode de réalisation, les moyens de blindage formant un circuit ouvert ne peuvent être parcourus par un courant induit par le champ magnétique généré par l'élément inductif. Par conséquent la mutuelle inductance qui existe entre ces moyens de blindage et l'élément inductif est très faible.

Dans un mode de réalisation de l'invention, les moyens de blindage comportent une plaque en matériau faiblement résistif placée perpendiculairement aux vecteurs du champ magnétique que l'élément inductif est destiné à développer, et composée d'une alternance de bandes et de fentes perpendiculaires à un courant que l'élément inductif pourrait induire dans la plaque, les bandes étant connectées à un cadre non fermé.

Une telle plaque, de par ces caractéristiques, bloque la propagation d'un champ électrique vers la zone active du circuit et fonctionne comme un circuit ouvert vis-à-vis d'un courant qui pourrait y être induit. La mutuelle inductance qui pourrait être générée avec l'élément inductif est donc presque nulle.

Dans un mode de réalisation de l'invention, les moyens de blindage comportent en outre un puits en matériau faiblement résistif dont les parois entourent entièrement l'élément inductif, ledit puits étant percé d'au moins une fente sur toute sa hauteur.

L'élément inductif, lorsqu'il est placé au voisinage d'un autre élément inductif, crée une mutuelle inductance avec cet autre élément inductif. Cette mutuelle inductance tend à détériorer le facteur de qualité de l'élément inductif. Le puits permet de limiter la création d'une telle mutuelle inductance en limitant l'interaction magnétique de l'élément inductif avec tout autre élément inductif présent dans le circuit. Une fente est percée sur toute la hauteur du puits pour empêcher l'établissement d'une boucle de courant à la surface du puits.

Dans un mode de réalisation avantageux de l'invention, la plaque et le puits sont reliés ensemble à une borne de référence de potentiel. Un but de la présente invention est de limiter les couplages capacitifs entre les éléments du circuit. En connectant le puits et la plaque ensemble et à un même potentiel la création de capacités parasites entre les différents éléments du circuit est limitée.

Le circuit intégré étant, en principe, composé d'une superposition de couches, chacune réalisée en un matériau faiblement résistif, les parois du puits sont constituées par un empilement de pistes, chacune découpée au sein d'une desdites couches autour d'un périmètre délimité par la surface de l'élément inductif, lesdites pistes étant connectées entre elles. Ce mode de réalisation de l'invention est simple et économique. L'implémentation du puits par l'utilisation des couches existantes n'augmente pas l'encombrement du circuit.

Dans un mode particulier de réalisation de l'invention, le circuit intégré comporte deux éléments inductifs, tous deux connectés entre une borne d'alimentation et une borne de référence de potentiel, et chacun constitué par une spire, lesdites spires ayant des sens de bobinage symétriques et opposés, les parties respectives desdites spires en vis-à-vis étant celles qui sont les plus éloignées de la borne d'alimentation. Le choix des sens de bobinages influe sur la valeur de la mutuelle inductance qui s'établit lorsqu'un courant parcourt les enroulements et influe donc sur la valeur du facteur de qualité. Ce choix est fait de façon à optimiser le facteur de qualité de l'élément inductif.

Chaque élément inductif sera avantageusement entouré d'un puits tel que décrit ci-dessus afin de réduire au maximum les interactions électromagnétiques entre lesdits éléments.

La présente invention peut être mise en oeuvre dans tout circuit intégré où un élément inductif coexiste avec d'autres éléments, qu'ils soient capacitifs, résistifs ou semiconducteurs. Le circuit intégré peut être par exemple un oscillateur, un mélangeur à charge active ou un filtre. Dans une de ses applications l'invention concerne donc également un oscillateur destiné à délivrer un signal de sortie ayant une fréquence dont la valeur dépend de la valeur d'une tension de réglage, caractérisé en ce qu'il est réalisé sous la forme d'un circuit intégré conforme à l'invention dont la zone active inclut au moins une diode de type varicap, reliée à l'élément inductif et destinée à être polarisée au moyen de la tension de réglage.

Plus généralement, la présente invention peut être avantageusement mise en oeuvre dans un appareil récepteur de signaux radioélectriques. L'invention concerne donc un appareil récepteur de signaux radioélectriques comportant :
- un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,
- un oscillateur local dont la fréquence dite d'oscillation est réglable en fonction d'une tension de réglage, et
- un mélangeur, destiné à recevoir le signal radio et un signal provenant de l'oscillateur local et à délivrer un signal de sortie ayant une fréquence fixée et égale à la différence entre la fréquence radio et la fréquence d'oscillation, et
- une unité de traitement du signal destinée à exploiter le signal de sortie du mélangeur, appareil caractérisé en ce que l'oscillateur local est conforme à l'oscillateur décrit précédemment.

L'invention sera mieux comprise à la lumière de la description suivante de quelques modes de réalisation, faite à titre d'exemple et en regard des dessins annexés, dans lesquels :
- la figure 1 est une vue en coupe d'un circuit intégré conforme à un mode de réalisation de l'invention,
- la figure 2 est une vue de dessus d'une plaque incluse dans un circuit intégré conforme à un mode de réalisation avantageux de l'invention,
- la figure 3 est une vue de dessus de deux éléments inductifs présents dans un circuit conforme à l'invention,
- la figure 4 est une vue en coupe d'un circuit intégré conforme à un mode de réalisation préféré de l'invention,
- la figure 5 est un schéma fonctionnel d'un oscillateur dont la réalisation est conforme à l'invention,
- la figure 6 est un schéma fonctionnel d'un appareil récepteur de signaux radioélectriques comprenant un oscillateur conforme à l'invention.

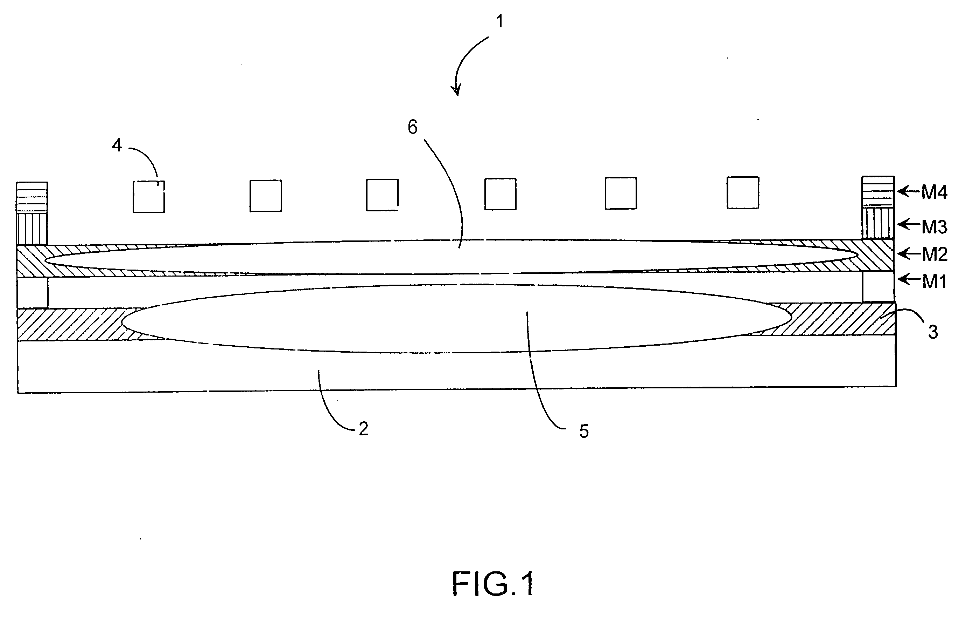

La figure 1 présente une vue en coupe d'un mode de réalisation particulier d'un circuit intégré conforme à la présente invention. Le circuit 1 est composé d'un substrat 2 qui peut être connecté à une borne de référence de potentiel et sur lequel sont superposées une première, une deuxième, une troisième, une quatrième et une cinquième couches de matériaux faiblement résistifs (3, M1, M2, M3 et M4). Le substrat 2 réalisé en polysilicium, la première couche 3 réalisée, elle aussi en polysilicium, et la deuxième couche M1 formée par un alliage métallique permettent de réaliser une zone active 5 du circuit qui comprend des éléments actifs, passifs et semiconducteurs. Dans le circuit intégré décrit ici, un élément inductif est réalisé dans le matériau formant la cinquième couche M4 du circuit de sorte que, ledit élément inductif 4 et une partie de la zone active 5 soient superposés. Des moyens de blindage 6 sont prévus pour isoler la zone active 5 vis-à-vis d'un champ électromagnétique que l'élément inductif 4 est destiné à développer. Les moyens de blindage 6 sont réalisés sur une couche, la troisième couche M2 dans cet exemple, placée entre la deuxième couche M1 et la cinquième couche M4, ces moyens de blindage 6 étant disposés perpendiculairement aux vecteurs du champ magnétique développé par l'élément inductif 4.

Dans le mode de réalisation décrit ici, les moyens de blindage 6 ne sont pas en contact avec l'élément inductif 4. La cinquième couche M4, sur laquelle est incorporé l'élément inductif 4, et la troisième couche M2, sur laquelle sont incorporés les moyens de blindage 6, sont en effet séparées par l'épaisseur de la quatrième couche M3. L'élément inductif 4 et lesdits moyens de blindage 6, considérés ensemble, peuvent former un élément L-C. Une capacité C formée entre l'élément inductif 4 et lesdits moyens de blindage 6 détériore le facteur de qualité de l'élément inductif. La valeur de cette capacité est fonction de la distance qui sépare les moyens de blindage de l'élément inductif. Pour minimiser cette valeur lesdits moyens de blindage sont éloignés de l'élément inductif.

Ce facteur de qualité sera encore amélioré si les moyens de blindage sont réalisés en un matériau faiblement résistif, comme c'est le cas dans cet exemple.

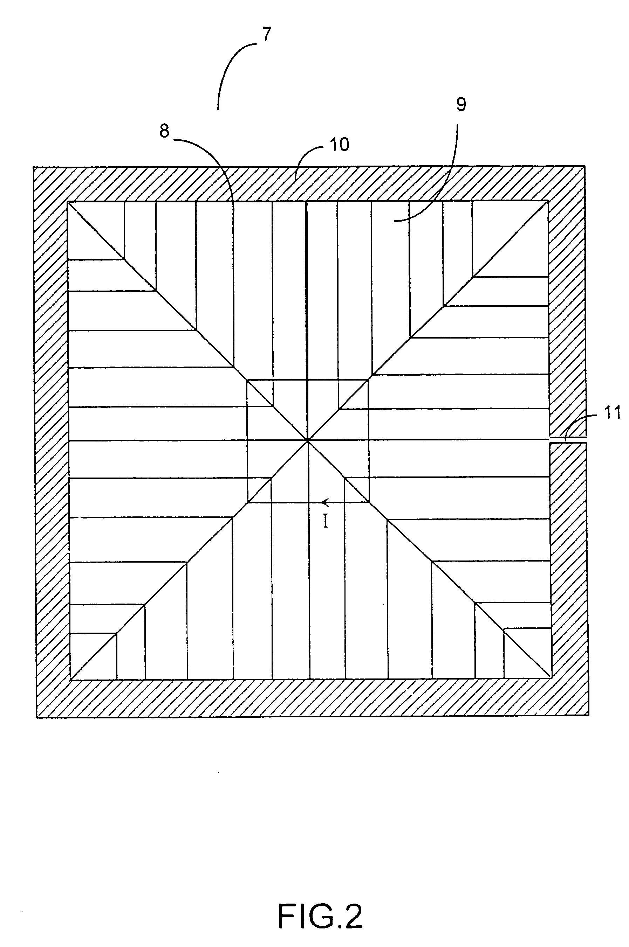

La figure 2 montre un mode de réalisation des moyens de blindage 6 décrits précédemment. Ces moyens de blindage 6 comportent une plaque en matériau faiblement résistif, placée perpendiculairement aux vecteurs du champ magnétique développé par l'élément inductif 4, et composée d'une alternance de bandes 8 et de fentes 9. Les bandes 8 sont par exemple réalisées en un alliage métallique ou en polysilicium. La plaque étant disposée perpendiculairement aux vecteurs du champ magnétique développé par l'élément inductif, un courant induit I pourrait apparaître dans la plaque si celle-ci était réalisée d'une seule pièce. L'alternance de fentes 9 et de bandes 8 disposées perpendiculairement à ce courant I forme un circuit ouvert empêchant la circulation de ce courant induit. Ce courant étant ainsi presque nul dans les moyens de blindage la mutuelle inductance qui peut apparaître entre ces moyens de blindage et l'élément inductif est, elle aussi, presque nulle. Ceci permet de ne pas détériorer le facteur de qualité de l'élément inductif. Les bandes, pour être maintenues en place, sont fixées à l'extérieur sur un cadre 10 non fermé. Une fente 11 sur le cadre 10 empêche la formation d'une boucle de courant sur le cadre.

Dans un mode particulier de réalisation de l'invention, l'ensemble 7, formé par l'association du cadre 10 et des bandes 8, est connecté à une borne de potentiel de référence ou masse. Pour un circuit symétrique la masse virtuelle du circuit est choisie. Le circuit intégré comportera le plus souvent un substrat connecté à la borne de référence. Le facteur de qualité de l'élément inductif est fonction de la valeur d'une première capacité parasite qui peut apparaître entre la plaque et l'élément inductif et de la valeur d'une deuxième capacité qui peut apparaître entre la plaque et le substrat. La connexion de la plaque à la borne de référence permet de limiter la première capacité parasite. De plus, le fait de placer la plaque au même potentiel que le substrat permet d'empêcher la formation de la deuxième capacité parasite, et le facteur de qualité de l'élément inductif n'est pas détérioré.

En outre, la connexion de la plaque et du substrat 2 au même potentiel de référence empêche la transmission d'un champ électrique entre la plaque et le substrat et donc aux éléments de la zone active. Le champ magnétique qui peut être développé par l'élément inductif au niveau de la zone active 5 est, lui, fortement atténué par la plaque.

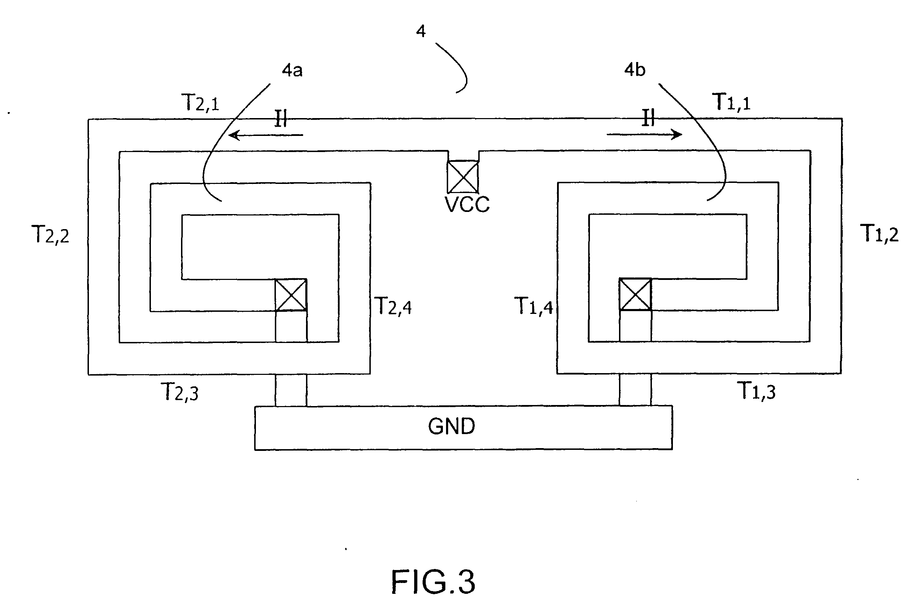

La figure 3 est une vue de dessus de deux éléments inductifs d'un circuit intégré conforme à un mode particulier de réalisation de l'invention. Ces deux éléments inductifs 4a, 4b, comprenant chacun une spire carrée {T_{1,1}, T_{1,2}, T_{1,3}, T_{1,4}} et {T_{2,1}, T_{2,2}, T_{2,3}, T_{2,4}}, sont symétriques et placés l'un à coté de l'autre. Ils sont tous deux connectés entre une borne d'alimentation VCC et une borne de référence de potentiel GND. Un courant Il les parcourt de la borne d'alimentation vers la borne de référence de potentiel. Ce mode de réalisation permet de minimiser les mutuelles inductances qui peuvent apparaître dans le circuit et qui détériorent le facteur de qualité de l'élément inductif et par conséquent les performances du circuit. Chaque spire {T_{1,1}, T_{1,2}, T_{1,3}, T_{1,4}} et {T_{2,1}, T_{2,2}, T_{2,3}, T_{2,4}}, se comporte comme un assemblage en série de quatre inductances, chaque inductance correspondant à une partie de la spire. La mutuelle inductance entre deux spires voisines est dépendante du choix des sens de bobinage des spires. Le choix des sens de bobinage est fait de telle façon que celles des parties desdites spires qui sont en vis-à-vis direct l'une de l'autre sont celles qui sont les plus éloignées de la borne d'alimentation. Des parties de spires placées en vis-à-vis créent une mutuelle inductance qui est d'autant plus forte que ces parties sont proches de la borne d'alimentation. Les sens de bobinage choisis ici pour les spires des éléments inductifs 4a, 4b permettent de réduire la mutuelle inductance car le couplage ne s'effectue que sur la quatrième partie de chaque spire T_{1,4} et T_{2,4}.

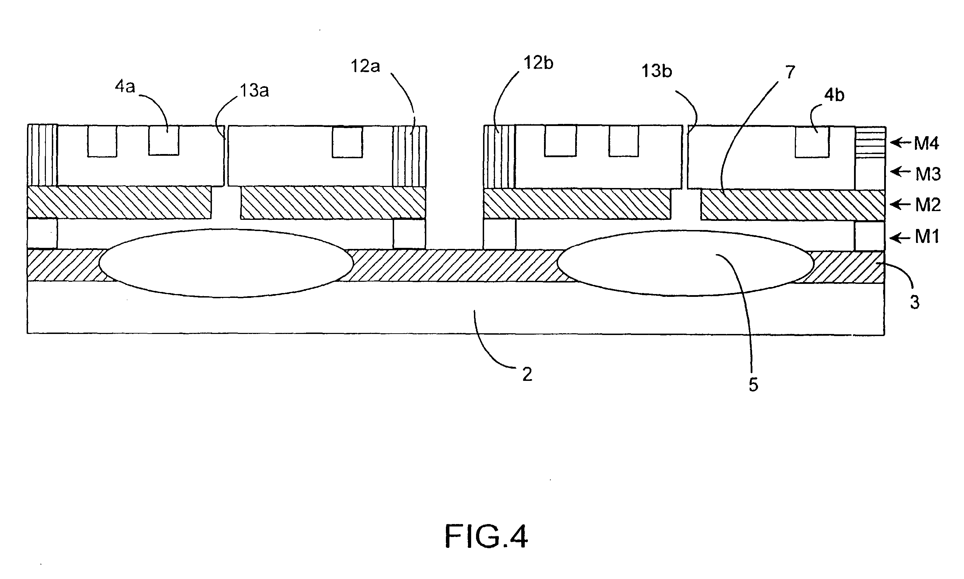

La figure 4 est une vue en coupe d'un circuit intégré conforme à un mode de réalisation préféré de l'invention. Ce circuit intégré comporte deux éléments inductifs 4a, 4b tels les deux éléments inductifs décrits dans le paragraphe précédent. Deux puits 12a et 12b sont formés autour des éléments inductifs 4a et 4b. Chaque puits 12a, 12b, réalisé ici en matériau conducteur, est à base carrée et ses parois entourent entièrement un des éléments inductifs 4a, 4b. Chaque puits 12a, 12b est percé sur toute sa hauteur d'une fente 13a, 13b qui interrompt toute circulation possible d'un courant induit par l'élément inductif 4a, 4b qu'il entoure. Ces puits 12a, 12b permettent de minimiser les mutuelles inductances entre les deux éléments inductifs 4a, 4b. Dans le mode de réalisation décrit ici, chaque puits 12a, 12b est réalisé par des jonctions de parties des couches M3 et M4. Ces puits sont suffisamment hauts pour assurer une bonne isolation entre les éléments inductifs 4a et 4b et limiter l'interaction magnétique entre ces éléments inductifs. De façon générale, chaque élément inductif ou partie d'élément inductif inclus dans le circuit intégré peut être isolé par des moyens de blindage comprenant un tel puits afin de minimiser les mutuelles inductances qui peuvent être développées entre cet élément inductif ou partie d'élément inductif et d'autres éléments présents dans le circuit.

Dans un mode de réalisation préféré de l'invention, la plaque et le puits sont reliés ensemble à une borne de référence de potentiel. Les couplages capacitifs parasites entre la plaque et le substrat d'une part, entre la plaque et l'élément inductif d'autre part et enfin, entre la plaque et le puits sont ainsi fortement limités. L'élément inductif inclus dans le circuit intégré de ce mode de réalisation préféré de l'invention présentera alors un facteur de qualité élevé.

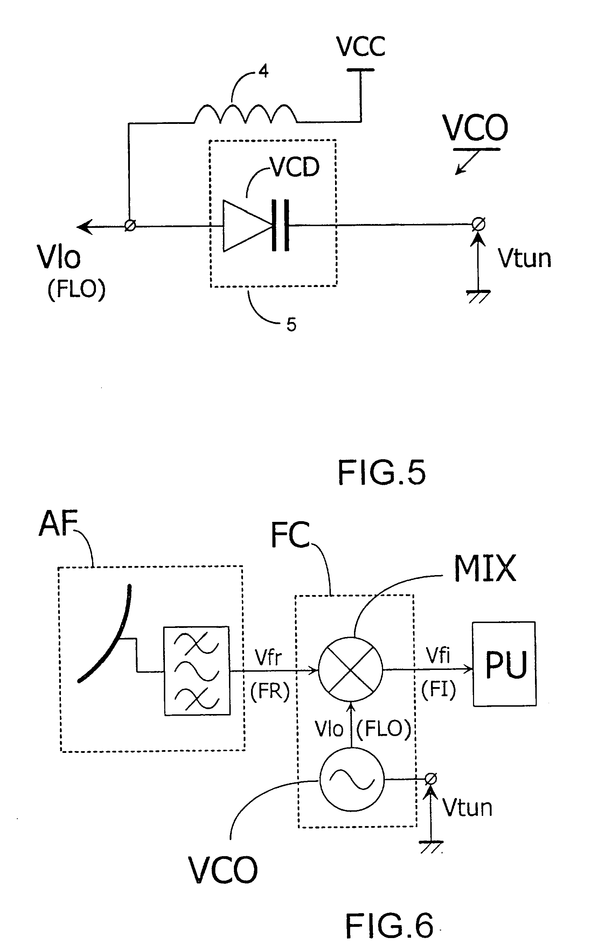

La figure 5 est un schéma fonctionnel d'un oscillateur réalisé sous la forme d'un circuit intégré conforme à l'invention. Cet oscillateur VCO est destiné à fournir un signal de tension Vlo ayant une fréquence FLO dont la valeur dépend d'une tension de réglage Vtun. Cet oscillateur comprend un élément inductif 4, connecté à une borne d'alimentation VCC, et une zone active 5 comportant une diode de type varicap VCD. La diode VCD est polarisée au moyen de la tension de réglage Vtun.

La figure 6 représente schématiquement un appareil récepteur de signaux radioélectriques, comportant un système d'antenne et de filtrage AF, permettant la réception d'un signal radioélectrique dont la fréquence FR, dite fréquence radio, est sélectionnée au sein d'une gamme de fréquences donnée, et sa transformation en un signal électronique Vfr dit signal radio. Cet appareil récepteur comporte en outre un convertisseur de fréquence FC, comprenant un oscillateur local VCO et un mélangeur MIX, lequel est destiné à recevoir le signal radio Vfr et un signal Vlo provenant de l'oscillateur local VCO dont la fréquence FLO, dite d'oscillation, est réglable, et à délivrer un signal de sortie Vfi ayant une fréquence FI fixée et égale à la différence entre la fréquence radio FR et la fréquence d'oscillation FLO.

Dans ce convertisseur de fréquence FC, le choix de la valeur de la fréquence d'oscillation FLO, effectué au moyen d'une tension de réglage Vtun, impose la valeur de la fréquence radio FR, puisque la fréquence intermédiaire FI est rendue fixe, par exemple à l'aide d'un système de filtrage non représenté sur la figure qui serait disposé en sortie du mélangeur MIX. Cet appareil récepteur comporte enfin une unité de traitement du signal PU destinée à exploiter le signal de sortie du mélangeur MIX.

## Revendications

1. Circuit intégré comprenant au moins un élément inductif (4), une zone dite active (5) pouvant inclure des éléments résistifs, capacitifs et semiconducteurs, ledit élément inductif et une partie de la zone active étant superposés, dans lequel le circuit est muni de moyens de blindage (6) pour isoler la zone active vis-à-vis d'un champ électro-magnetique que l'élément inductif est destiné à développer, et dans lequel les moyens de blindage comportent une plaque en matériau faiblement résistif (7); placée perpendiculairement aux vecteurs du champ magnétique que l'élément inductif est destiné à développer, et composée d'une alternance de bandes (8) et de fentes (9) perpendiculaires à un courant que l'élément inductif pourrait induire dans la plaque, les bandes étant connectées à un cadre (10) non fermé, **caractérisé en ce que** les moyens de blindage comportent en outre un puits (12) en matériau faiblement résistif dont les parois entourent entièrement l'élément inductif, ledit puits étant percé d'au moins une fente sur toute sa hauteur..

2. Circuit intégré selon la revendication 1, **caractérisé en ce que** les moyens de blindage sont placés entre l'élément inductif et la zone active et forment un circuit ouvert.

3. Circuit intégré selon la revendication 1 **caractérisé en ce que** la plaque et le puits sont reliés ensemble à une borne référence de potentiel.

4. Circuit intégré selon la revendication 1, **caractérisé en ce que** le circuit intégré est composé d'une superposition de couches, chacune réalisée en un matériau faiblement résistif, les parois du puits sont constituées par un empilement de pistes, chacune découpée an sein d'une desdites couches autour d'un périmètre délimité par la surface de l'élément inductif, lesdites pistes étant connectées entre elles.

5. Circuit intégré selon la revendication 1, **caractérisé en ce qu'**il comporte deux éléments inductifs, tous deux connectés entre une borne d'alimentation et une borne de référence de potentiel, et chacun constitué par une spire, lesdites spires ayant des sens de bobinage symétriques et opposés, celles des parties respectives desdites spires qui sont en vis-à-vis direct l'une de l'autre étant celles qui sont les plus éloignées de la borne d'alimentation.

6. Oscillateur destiné à délivrer un signal de sortie ayant une fréquence dont la valeur dépend de la valeur d'une tension de réglage, **caractérisé en ce qu'**il est réalisé sous la forme d'un circuit intégré conforme à la revendication 1, dont la zone active inclut au moins une diode de type varicap reliée à l'élément inductif et destinée à être polarisée au moyen de la tension de réglage.

7. Appareil récepteur de signaux radioélectriques, comportant :
. un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,
. un oscillateur local dont la fréquence dite d'oscillation est réglable en fonction d'une tension de réglage, et
. un mélangeur, destiné à recevoir le signal radio et un signal provenant de l'oscillateur local et à délivrer un signal de sortie ayant une fréquence fixée et égale à la différence entre la fréquence radio et la fréquence d'osciliation, et
. une unité de traitement du signal destinée à exploiter le signal de sortie du mélangeur, appareil **caractérisé en ce que** l'oscillateur local est conforme à la revendication 6.

## Claims

1. An integrated circuit comprising at least an inductive element (4), and a region called active region (5) which may include resistive, capacitive and semiconductor elements, said inductive element and part of the active region being superimposed, in which the integrated circuit comprises screening means (6) for isolating the active region from an electromagnetic field that the inductive element is intended to develop, in which the screening means comprise a plate of low-resistive material (7) placed perpendicular to the vectors of the magnetic field intended to be developed by the inductive element, and formed by an alternation of bands (8) and slots (9) perpendicular to a current that could be induced in the plate by the inductive element, the bands being connected to an open frame (10), **characterized in that** the screening means further include a via hole (12) of low-resistance material whose walls surround the inductive element completely, said via hole having at least one slot over its entire height.

2. An integrated circuit as claimed in claim 1, **characterized in that** the screening means are placed between the inductive element and the active region and form an open circuit.

3. An integrated circuit as claimed in claim 1, **characterized in that** the plate and the via hole are together connected to a reference terminal having potential.

4. An integrated circuit as claimed in claim 1, **characterized in that** as the integrated circuit is basically formed by a superposition of layers, each realized of a low-resistance material, the walls of the via hole are formed by a stacking of tracks, each cut out in one of said layers around a perimeter defined by the surface of the inductive element, while said tracks are interconnected.

5. An integrated circuit as claimed in claim 1, **characterized in that** the integrated circuit comprises two inductive elements, the two being connected between a supply terminal and a reference terminal having potential, and each formed by a turn, said turns having symmetrical and opposite directions of coil winding, the respective parts of said facing turns being those that are farthest away from the power supply terminal.

6. An oscillator intended to deliver an output signal that has its frequency whose value depends on the value of a tuning voltage, **characterized in that** the oscillator is realized in the form of an integrated circuit as claimed in claim 1, of which the active region includes at least a varicap diode connected to the inductive element and intended to be biased by means of the tuning voltage.

7. An apparatus for receiving radio signals, comprising:
- an antenna and filter system permitting to receive a radio signal whose frequency, called radio frequency, is selected within a given frequency range, and its transformation into an electronic signal called radio signal,
- a local oscillator whose frequency called oscillation frequency can be tuned as a function of a tuning voltage, and
- a mixer, intended to receive the radio signal and a signal coming from the local oscillator and to deliver an output signal having a fixed frequency and equal to the difference between the radio frequency and the oscillation frequency, and
- a signal processing unit intended to use the output signal of the mixer, which apparatus is **characterized in that** the local oscillator is in accordance with claim 6.

## Patentansprüche

1. Integrierter Schaltkreis mit zumindest einem induktiven Element (4), einem als aktiv bezeichneten Bereich (5), der Widerstands-, kapazitive und Halbleiterelemente einschließt, wobei sich das induktive Element und ein Abschnitt des aktiven Bereichs überlagern, wobei der Schaltkreis mit Abschirmungsmitteln (6) zur Trennung des aktiven Bereichs gegenüber einem elektromagnetischen Feld ausgestattet ist, zu dessen Entwicklung das induktive Element bestimmt ist, und wobei die Abschirmungsmittel eine Platte aus einem Werkstoff mit geringem Widerstand (7) umfassen, die rechtwinklig zu den Vektoren des Magnetfelds angeordnet ist, zu dessen Entwicklung das induktive Element bestimmt ist, und sich abwechselnd aus Bändern (8) und Schlitzen (9) rechtwinklig zu einem Strom, den das induktive Element eventuell in die Platte induziert, zusammensetzen, wobei die Bänder mit einem nicht geschlossenen Rahmen (10) verbunden sind, **dadurch gekennzeichnet, dass** die Abschirmungsmittel darüber hinaus eine Vertiefung (12) aus einem Werkstoff mit geringem Widerstand aufweisen, deren Wände das induktive Element vollständig umschließen, wobei diese Vertiefung über ihre ganze Höhe zumindest von einem Schlitz durchbrochen wird.

2. Integrierter Schaltkreis nach Anspruch 1, **dadurch gekennzeichnet, dass** die Abschirmungsmittel zwischen dem induktiven Element und dem aktiven Bereich angeordnet sind und einen offenen Schaltkreis bilden.

3. Integrierter Schaltkreis nach Anspruch 1, **dadurch gekennzeichnet, dass** die Platte und die Vertiefung gemeinsam mit einer Potentialreferenzklemme verbunden sind.

4. Integrierter Schaltkreis nach Anspruch 1, **dadurch gekennzeichnet, dass** der integrierte Schaltkreis aus übereinander gelagerten Schichten besteht, die jeweils aus einem Werkstoff mit geringem Widerstand gefertigt sind, wobei die Wände der Vertiefung von einer Stapelung von Spuren gebildet werden, die jeweils innerhalb einer der Schichten um einen Umfang ausgeschnitten sind, der durch die Fläche des induktiven Elements begrenzt ist, wobei die Spuren untereinander verbunden sind.

5. Integrierter Schaltkreis nach Anspruch 1, **dadurch gekennzeichnet, dass** er zwei induktive Elemente aufweist, die beide zwischen einer Versorgungsklemme und einer Potentialreferenzklemme verbunden sind und jeweils aus einer Windung bestehen, wobei die Windungen symmetrische und entgegengesetzte Wicklungsrichtungen aufweisen, wobei diejenigen der jeweiligen Abschnitte der Windungen, die einander direkt gegenüber liegen, die Windungen sind, die am weitesten von der Versorgungsklemme entfernt sind.

6. Oszillator, der dazu bestimmt ist, ein Ausgangssignal mit einer Frequenz zu liefern, deren Wert vom Wert einer Regelungsspannung abhängt, **dadurch gekennzeichnet, dass** er in Form eines integrierten Schaltkreises nach Anspruch 1 ausgeführt ist, dessen aktiver Bereich zumindest eine Varicap-Diode einschließt, die mit dem induktiven Element verbunden ist und dazu bestimmt, mittels der Regelungsspannung polarisiert zu werden.

7. Empfangsvorrichtung für funkelektrische Signale, umfassend:
- ein Antennen- und Filtersystem, das den Empfang eines funkelektrischen Signals erlaubt, dessen Frequenz, Funkfrequenz genannt, aus einem vorgegebenen Frequenzbereich ausgewählt ist, und seine Umwandlung in ein elektronisches Signal, Funksignal genannt,
- einen lokalen Oszillator, dessen als Schwingungsfrequenz bezeichnete Frequenz in Abhängigkeit einer Regelungsspannung einstellbar ist, und
- einen Mischer, der dazu bestimmt ist, das Funksignal zu empfangen und ein Signal vom lokalen Oszillator, und ein Ausgangssignal bereitzustellen, das eine festgelegte Frequenz gleich der Differenz zwischen der Funkfrequenz und der Schwingungsfrequenz aufweist, und
- eine Einheit zur Verarbeitung des Signals, die dazu bestimmt ist, das Ausgangssignal des Mischers zu verwenden, wobei diese Vorrichtung **dadurch gekennzeichnet ist, dass** der lokale Oszillator Anspruch 6 entspricht.
